# EUROPEAN PATENT APPLICATION

(11) **EP 4 661 222 A1**
(43) Date of publication of application: **10.12.2025**
(21) Application number: 24771240.9
(22) Date of filing: 26.02.2024
(51) Int. Cl.: H01R 13/652, H01R 13/629, H04M 1/02, H01R 103/00

(54) **ELECTRONIC DEVICE COMPRISING CONNECTOR**

(30) Priority: 14.03.2023 KR 20230033093; 27.03.2023 KR 20230039687
(71) Applicant: Samsung Electronics Co., Ltd., Suwon-si, Gyeonggi-do 16677 (KR)
(72) Inventor: PARK, Sungwu, Suwon-si, Gyeonggi-do 16677 (KR); KIM, Jeongseob, Suwon-si, Gyeonggi-do 16677 (KR); HAN, Junhee, Suwon-si, Gyeonggi-do 16677 (KR)
(74) Representative: Gulde & Partner
(86) International application number: PCT/KR2024/095448
(87) International publication number: WO 2024/191241

(57) **Abstract**

An electronic device according to one embodiment of the present disclosure comprises an electronic component, a multilayer printed circuit board, and a connector, wherein the multilayer printed circuit board comprises: a first printed circuit board including a first conductive pad and a second conductive pad electrically coupled to the electronic component; a second printed circuit board; and a third printed circuit board disposed between the first printed circuit board and the second printed circuit board, the connector comprises: a signal pin electrically connected to the first conductive pad; a ground pin of which at least a portion is inserted into the second conductive pad; and a coupling region, and the coupling region may be disposed in the lateral direction of the third printed circuit board.

## Description

### [Technical Field]

The disclosure relates to an electronic device including a connector.

### [Background Art]

With the development of communication technology, the number of antennas required in electronic devices is increasing. To avoid interference between antennas, the number of antennas that are placed outside a printed circuit board without direct contact with the printed circuit board is also increasing.

Electronic devices may include coaxial connectors and coaxial cables that connect a printed circuit board to an antenna located outside the printed circuit board. The coaxial connectors and the coaxial cables may be used to reduce the loss of radio frequency (RF) signals along the path from the printed circuit board to the antennas located outside the printed circuit board.

### [Disclosure of Invention]

### [Technical Problem]

Due to the miniaturization of electronic devices, the size of printed circuit boards is decreasing. However, the number of coaxial connectors and coaxial cables required in electronic devices is increasing due to the growing number of antennas.

Since coaxial connectors and coaxial cables are arranged on one surface of the printed circuit board, the increase in the number of coaxial connectors and coaxial cables may limit the available space for placing other components on the printed circuit board.

In addition, mechanical supports may be needed on the printed circuit board to securely maintain the fastening state of the coaxial connector.

Moreover, since the coaxial cables need to be manually fastened by the device manufacturer, surrounding components placed on the printed circuit board may be damaged during the fastening process of the coaxial cable.

### [Solution to Problem]

An electronic device according to one embodiment of the disclosure may include an electronic component, a multilayer printed circuit board, and a connector.

In an embodiment, the electronic component may be disposed on one surface of the multilayer printed circuit board.

In an embodiment, the connector may be disposed on one side of the multilayer printed circuit board.

In an embodiment, the multilayer printed circuit board may include a first printed circuit board, a second printed circuit board, and a third printed circuit board disposed between the first printed circuit board and the second printed circuit board, the first printed circuit board including a first conductive pad electrically connected to the electronic component and a second conductive pad having an aperture shape.

In an embodiment, the connector may include a signal pin in contact with the first conductive pad to be electrically connected thereto, a ground pin having at least a portion inserted into the second conductive pad so as to be electrically connected to the second conductive pad, and a coupling region which is electrically connected to the signal pin and the ground pin, and to which a cable positioned outside the connector is coupled.

In an embodiment, the coupling region may be disposed in the lateral direction of the third printed circuit board to face in a direction perpendicular to one surface of the first printed circuit board on which the first conductive pad is disposed.

An electronic device according to an embodiment of the disclosure may include a multilayer printed circuit board and a connector.

In an embodiment, the multilayer printed circuit board may include a plurality of conductive pads on one surface thereof.

In an embodiment, the connector may be disposed on one side of the multilayer printed circuit board.

In an embodiment, the connector may include a signal pin electrically connected to one or more conductive pads among the plurality of conductive pads and a ground pin electrically connected to one or more of the remaining conductive pads among the plurality of conductive pads.

In an embodiment, the length of the multilayer printed circuit board extending in the vertical direction of the multilayer printed circuit board may be longer than the length of the connector extending in the vertical direction of the connector.

An electronic device according to an embodiment of the disclosure may include a printed circuit board and a connector.

In an embodiment, the connector may be disposed on one side of the printed circuit board.

In an embodiment, the printed circuit board may include an installation space which has a recessed shape toward the inner side of the printed circuit board and in which the connector is disposed, and conductive pads respectively disposed in one direction and the other direction of the installation space, each of the conductive pads having an aperture shape.

In one embodiment, the connector may include ground pins respectively extending from one side and the other side of the connector, each of the ground pins having at least a portion inserted into the conductive pad so as to be electrically connected to the conductive pad.

### [Advantageous Effects of Invention]

An electronic device including a connector according to an embodiment of the disclosure may include the connector arranged at a lateral surface of a printed circuit board, thereby ensuring available space for mounting other components on the printed circuit board.

An electronic device including a connector according to an embodiment of the disclosure may include the connector arranged at a lateral surface of a printed circuit board, thereby eliminating the need to configure a separate mechanical support structure on the printed circuit board.

An electronic device including a connector according to an embodiment of the disclosure may include the connector arranged at a lateral surface of a printed circuit board, thereby reducing the overall thickness of the printed circuit board and the overall size of the electronic device.

An electronic device including a connector according to an embodiment of the disclosure may include the connector arranged at a lateral surface of a printed circuit board, thereby preventing or reducing damage to surrounding components mounted on the printed circuit board during coupling of a coaxial cable.

### [Brief Description of Drawings]

FIG. 1 is a block diagram of an electronic device in a network environment according to an embodiment.
FIGS. 2A and 2B each illustrate a connector according to an embodiment of the disclosure.
FIGS. 3A, 3B, 3C, and 3D each illustrate a connector and a multilayer printed circuit board according to an embodiment of the disclosure.
FIG. 4 illustrates a connector according to an embodiment of the disclosure.
FIG. 5 illustrates a multilayer printed circuit board according to an embodiment of the disclosure.
FIG. 6 illustrates a cable support member and a multilayer printed circuit board according to an embodiment of the disclosure.
FIGS. 7A and 7B each illustrate a connector according to an embodiment of the disclosure.
FIGS. 8A and 8B each illustrate a multilayer printed circuit board and a connector arranged on the multilayer printed circuit board according to an embodiment of the disclosure.
FIGS. 9A, 9B, and 9C each illustrate a printed circuit board and a connector according to an embodiment of the disclosure.
FIGS. 10A and 10B each illustrate an electronic device according to an embodiment of the disclosure.

### [Mode for the Invention]

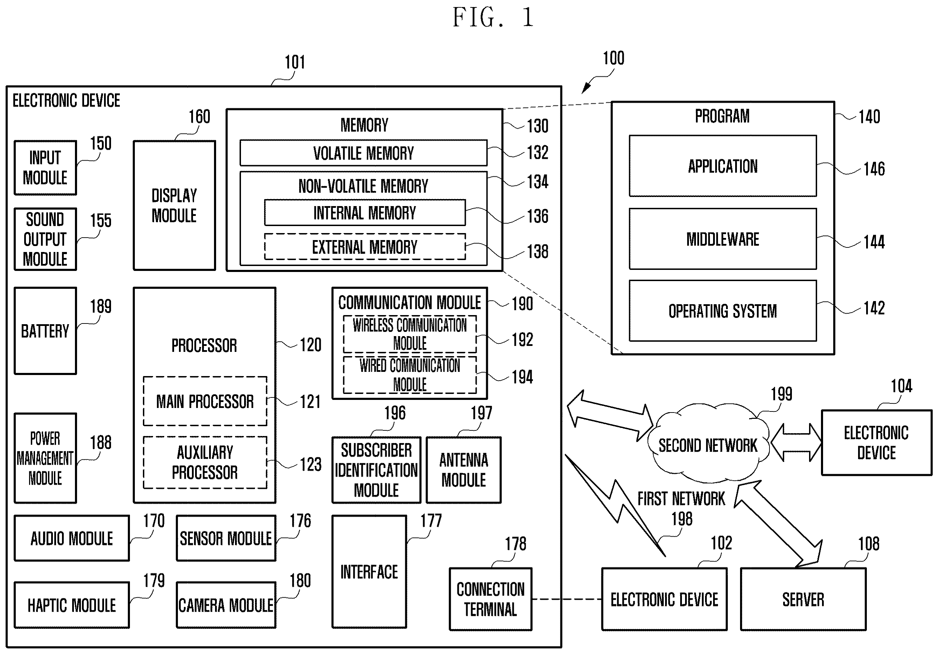

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or a processor), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as BluetoothTM, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to one embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

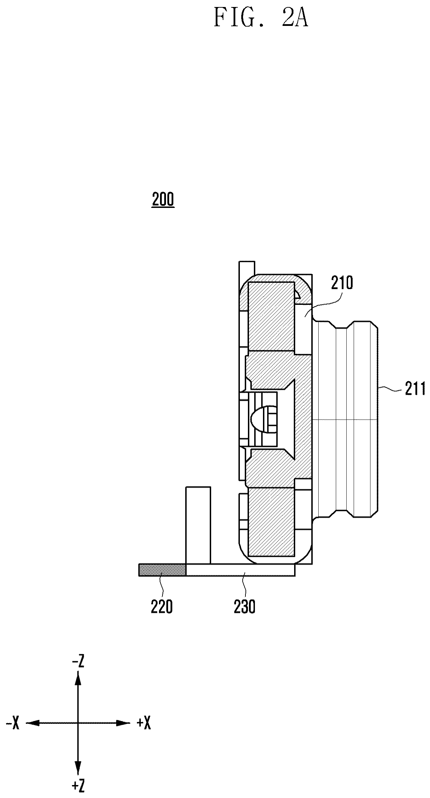

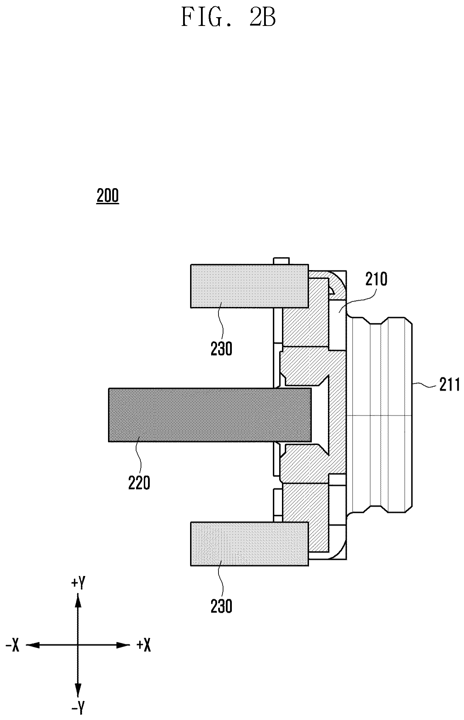

FIGS. 2A and 2B each illustrate a connector 200 according to an embodiment of the disclosure.

In describing the connector 200 according to an embodiment of the disclosure, the longitudinal direction of the connector 200 may refer to the x-axis direction, and the lateral direction of the connector 200 may refer to the y-axis direction. The vertical direction of the connector 200 may refer to the z-axis direction.

In an embodiment, the connector 200 may include a body 210, a signal pin 220, and/or a ground pin 230.

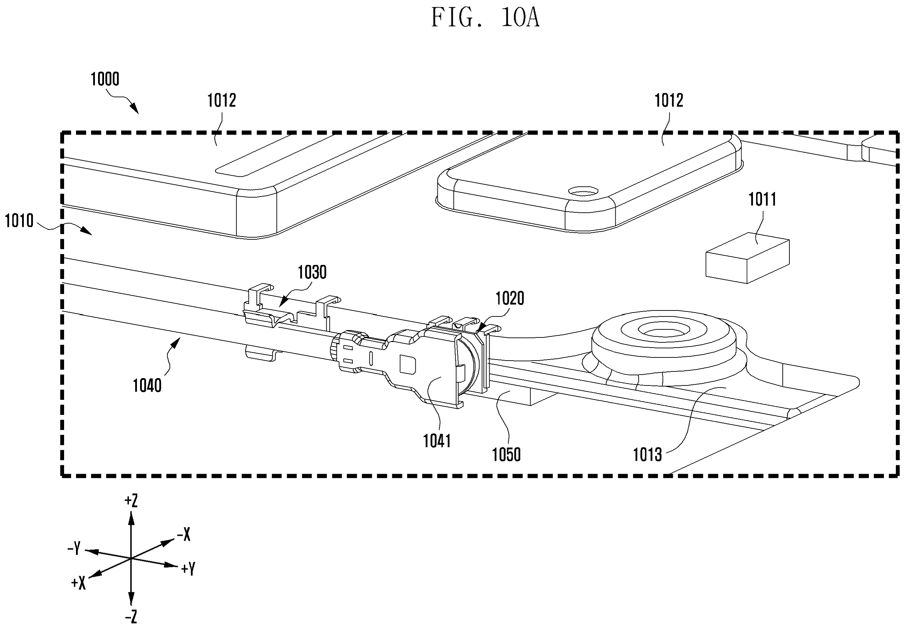

In an embodiment, the body 210 may include a coupling region 211. The coupling region 211 may extend in one direction (e.g., the positive x-axis direction) of the body 210. The coupling region 211 may be a region to which a cable 1040 (see FIG. 10A) is coupled. The coupling region 211 may be electrically connected to the signal pin 220 and the ground pin 230.

In an embodiment, the signal pin 220 and the ground pin 230 may be arranged at one end of the body 210. For example, the signal pin 220 and the ground pin 230 may be arranged at the end of the body 210 in the positive z-axis direction.

In an embodiment, the signal pin 220 may extend in the longitudinal direction of the connector 200. For example, the signal pin 220 may extend from one end of the body 210 in a direction away from the body 210, along the longitudinal direction of the connector 200 (e.g., the x-axis direction).

In an embodiment, the signal pin 220 may be a pin that serves to transmit and receive an electrical signal. The ground pin 230 may be a pin for electrically connecting the connector 200 to the ground.

In an embodiment, the ground pin 230 may be bent at least in a portion thereof and extend from the bent portion. For example, referring to FIG. 2A, the ground pin 230 may extend in the longitudinal direction of the connector 200 (e.g., the negative x-axis direction) and then bend and extend in the vertical direction of the connector 200 (e.g., the negative z-axis direction).

In an embodiment, the connector 200 may include at least one ground pin 230. For example, referring to FIG. 2B, the connector 200 may include two ground pins 230. However, the number of ground pins 230 shown in FIG. 2B is exemplary, and the number of ground pins 230 may not be limited thereto.

In an embodiment, the ground pins 230 may be arranged in the lateral direction (e.g., the y-axis direction) of the connector 200 to be spaced apart from each other with the signal pin 220 interposed therebetween.

In an embodiment, the two ground pins 230 may be arranged symmetrically with respect to the signal pin 220. For example, one ground pin 230 may be positioned in one direction (e.g., the positive y-axis direction) with respect to the signal pin 220, and the other ground pin 230 may be positioned in the other direction (e.g., the negative y-axis direction) with respect to the signal pin 220.

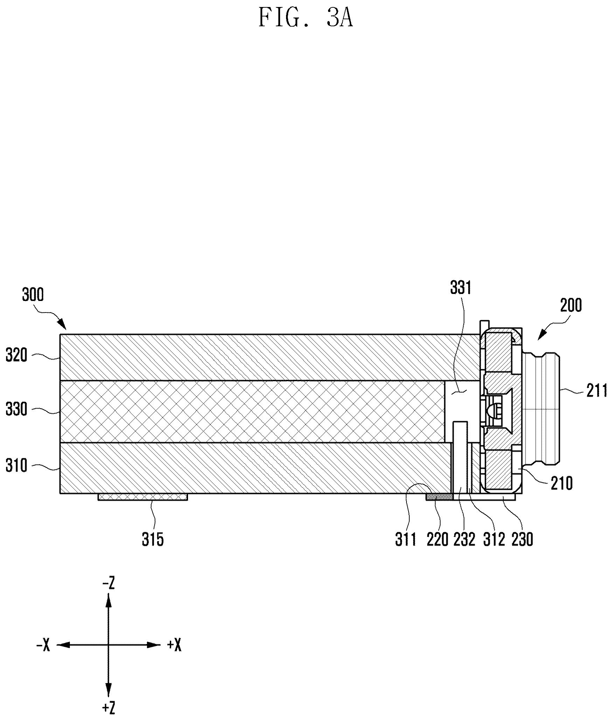

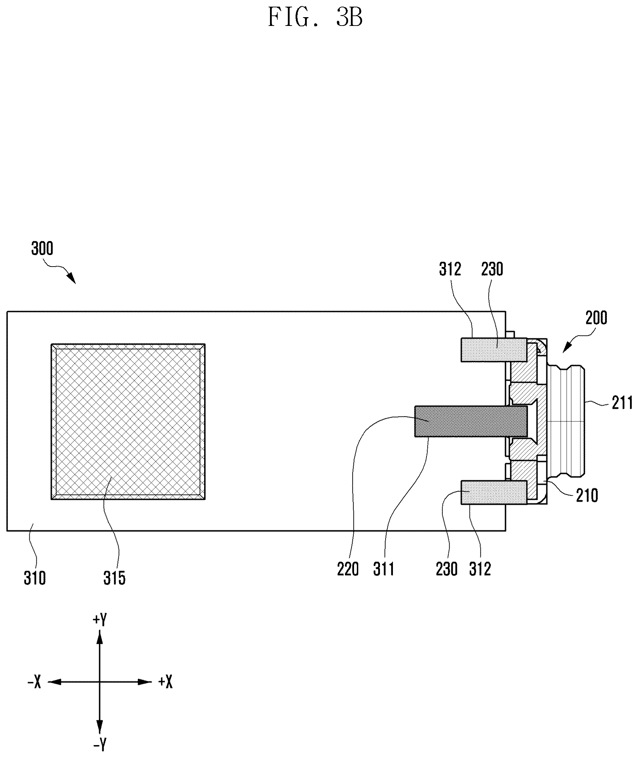

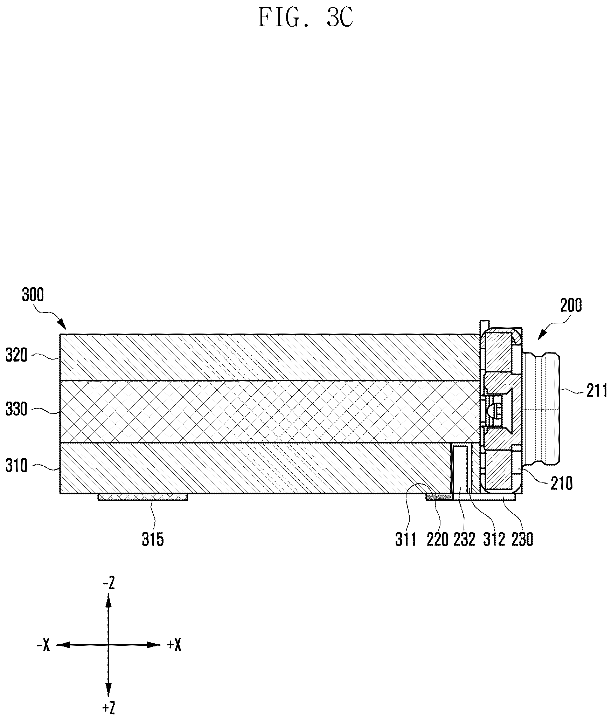

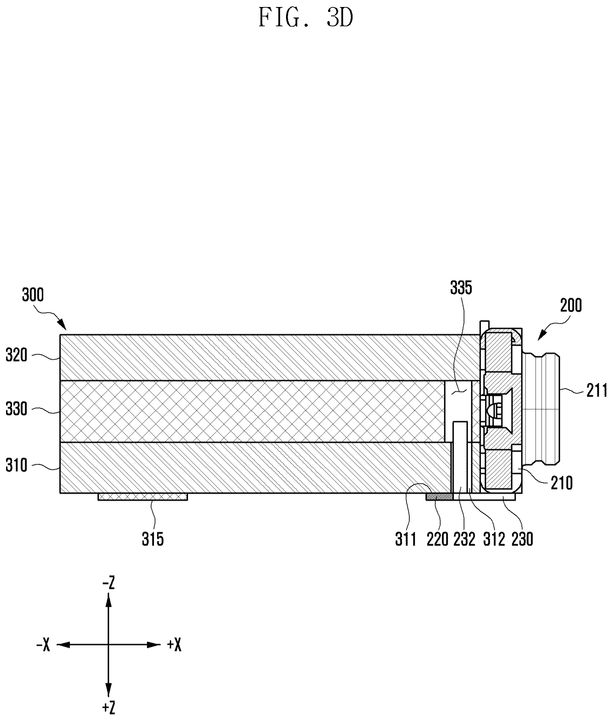

FIGS. 3A, 3B, 3C, and 3D each illustrate a connector 200 and a multilayer printed circuit board 300 according to an embodiment of the disclosure.

In an embodiment, the vertical direction of the multilayer printed circuit board 300 may refer to the z-axis direction. The lateral direction and the longitudinal direction of the multilayer printed circuit board 300 may be directions perpendicular to the vertical direction.

FIG. 3A illustrates the connector 200 arranged on the multilayer printed circuit board 300 according to an embodiment. FIG. 3B illustrates the connector 200 arranged on the multilayer printed circuit board 300 when viewed in the vertical direction of the multilayer printed circuit board 300.

FIG. 3C illustrates a third printed circuit board 330 according to an embodiment. FIG. 3D illustrates the third printed circuit board 330 including an interference-avoidance opening 335.

An electronic device 101 (see FIG. 1) according to an embodiment of the disclosure may include the multilayer printed circuit board 300, an electronic component 315, and/or the connector 200.

In an embodiment, the multilayer printed circuit board 300 may include a first printed circuit board 310, a second printed circuit board 320, and/or the third printed circuit board 330.

In an embodiment, along the vertical direction (e.g., the z-axis direction) of the multilayer printed circuit board 300, the first printed circuit board 310, the third printed circuit board 330, and the second printed circuit board 320 may be stacked in that order. For example, the third printed circuit board 330 may be disposed between the first printed circuit board 310 and the second printed circuit board 320.

In an embodiment, the first printed circuit board 310 and the second printed circuit board 320 may be substrates on which a component (e.g., the electronic component 315) necessary for the operation of the electronic device 101 (see FIG. 1) are arranged. The third printed circuit board 330 may be an interposer substrate that electrically connects the first printed circuit board 310 and the second printed circuit board 320.

In an embodiment, the electronic component 315 may be arranged on one surface of the first printed circuit board 310. For example, the electronic component 315 may be arranged on the surface of the first printed circuit board 310 facing the positive z-axis direction.

In an embodiment, the electronic component 315 may be an integrated circuit (IC) included in the electronic device 101 (see FIG. 1). For example, the electronic component 315 may be a processor 120 (see FIG. 1) and/or a memory 130 (see FIG. 1) in the form of an integrated circuit.

In an embodiment, the connector 200 may be disposed on one side of the multilayer printed circuit board 300. For example, referring to FIGS. 3A and 3B, the connector 200 may be disposed on the lateral surface of the multilayer printed circuit board 300 facing the positive x-axis direction.

In an embodiment, the connector 200 may be a component (e.g., a coaxial connector) for electrically connecting an antenna module 197 (see FIG. 1) located outside of the multilayer printed circuit board 300 to the multilayer printed circuit board 300. For example, a cable 1040 (see FIG. 10A) connected to the antenna module 197 (see FIG. 1) may be coupled to the connector 200 so that the antenna module 197 (see FIG. 1) and the multilayer printed circuit board 300 may be electrically connected to each other.

In an embodiment, the first printed circuit board 310 may include a first conductive pad 311 and/or a second conductive pad 312.

In an embodiment, the first conductive pad 311 may be disposed on one surface of the first printed circuit board 310. The first conductive pad 311 may be electrically connected to an electronic component 315.

In an embodiment, the first conductive pad 311 may be a pad that is in contact with the signal pin 220. The signal pin 220 may be in contact with the first conductive pad 311 and may be electrically connected thereto.

In an embodiment, the second conductive pad 312 may have an aperture shape. For example, the second conductive pad 312 may have an aperture shape disposed in a portion of the first printed circuit board 310 and may extend in the vertical direction (e.g., the z-axis direction).

In an embodiment, the second conductive pad 312 may be electrically connected to a ground (e.g., a ground pattern) of the multilayer printed circuit board 300.

In an embodiment, the second conductive pad 312 may be a pad that is in contact with the ground pin 230. The second conductive pad 312 may be in contact with the ground pin 230 and may be electrically connected thereto. The ground pin 230 may be in contact with the second conductive pad 312 and may be electrically connected to the ground of the multilayer printed circuit board 300. The ground pin 230 may serve to electrically connect the connector 200 to the ground of the multilayer printed circuit board 300.

In an embodiment, at least a portion of the ground pin 230 may be inserted into the second conductive pad 312. For example, the contact region 232 of the ground pin 230 may extend in the vertical direction (e.g., the z-axis direction) of the connector 200 and may be inserted into the second conductive pad 312.

In an embodiment, the ground pin 230 may be inserted into the second conductive pad 312 and may serve to fix the position of the connector 200 to the lateral surface of the multilayer printed circuit board 300.

In an embodiment, the ground pin 230 may be joined to the second conductive pad 312 by soldering. The ground pin 230 and the second conductive pad 312 may be soldered together, thereby fixing the position of the connector 200 to the lateral surface of the multilayer printed circuit board 300.

In an embodiment, the coupling region 211 of the connector 300 may be disposed in a lateral direction of the third printed circuit board 330 (e.g., the positive x-axis direction relative to the third printed circuit board 330), so as to face a direction (e.g., the surface facing the z-axis direction) substantially perpendicular to one surface of the first printed circuit board 310 on which the first conductive pad 311 is disposed.

In an embodiment, the third printed circuit board 330 may include a cutout region 331. The cutout region 331 may be a region for avoiding interference with the ground pin 230. A portion of the third printed circuit board 330 may be removed whereby contact between the ground pin 230 and the third printed circuit board 330 is prevented in the cutout region 331. For example, the end of the contact region 232 of the ground pin 230 may be located within the cutout region 331 of the third printed circuit board 330. The contact region 232 of the ground pin 230 may be located within the cutout region 331, and contact between the ground pin 230 and the third printed circuit board 330 may be avoided.

In an embodiment, the cutout region 331 may be disposed on a position on one side of the third printed circuit board 330, the position overlapping the end of the ground pin 230. For example, the cutout region 331 may be disposed at the side of the third printed circuit board 330 that faces the connector 200. The cutout region 331 may be disposed in a direction (e.g., the negative z-axis direction) toward the third printed circuit board 330 from the end (e.g., the end in the negative z-axis direction) of the contact region 232 of the ground pin 230.

In an embodiment, the multilayer printed circuit board 300 may serve to support the connector 200. For example, the multilayer printed circuit board 300 may be in contact with the body 210 of the connector 200, thereby supporting the connector 200 such that the connector 200 maintains a predetermined position thereof.

In an embodiment, the length of the multilayer printed circuit board 300 extending in the vertical direction (e.g., the z-axis direction) may be substantially equal to or greater than the length of the connector 200 extending in the vertical direction (e.g., the z-axis direction). The length of the multilayer printed circuit board 300 extending in the vertical direction (e.g., the z-axis direction) may be substantially equal to or greater than the length of the connector 200, thereby allowing the connector 200 to be stably supported by the multilayer printed circuit board 300.

In an embodiment, the multilayer printed circuit board 300 may include four or more printed circuit boards. For example, the multilayer printed circuit board 300 may additionally include at least one printed circuit board stacked on one surface of the second printed circuit board 320.

Referring to FIG. 3A, although the signal pin 220 and the ground pin 230 are illustrated as being disposed on the first printed circuit board 310, the signal pin 220 and the ground pin 230 may also be disposed on the second printed circuit board 320. In this case, the second printed circuit board 320 may include a conductive pad (not shown) that is in contact with the signal pin 220 and the ground pin 230.

Referring to FIG. 3C, the multilayer printed circuit board 300 according to an embodiment may be configured such that the third printed circuit board 330 does not include a separate cutout region 331. Even without the cutout region 331, the third printed circuit board 330 according to an embodiment may not be in contact with the ground pin 230. For example, referring to FIG. 3C, in an embodiment, the length of the first printed circuit board 310 extending in the vertical direction (e.g., the z-axis direction) of the multilayer printed circuit board 300 may be greater than the length of the contact region 232 of the ground pin 230 extending in the vertical direction (e.g., the z-axis direction). Accordingly, the ground pin 230 disposed on the multilayer printed circuit board 300 may be positioned spaced apart from the third printed circuit board 330 in the vertical direction (e.g., the z-axis direction) without coming into contact with the third printed circuit board 330.

Referring to FIG. 3D, in an embodiment, the third printed circuit board 330 of the multilayer printed circuit board 300 may include an interference-avoidance opening 335. The interference-avoidance opening 335 may be an opening disposed at a position overlapping the second conductive pad 312. In case that the third printed circuit board 330 includes the interference-avoidance opening 335, even when the ground pin 230 extends farther in the vertical direction (e.g., the z-axis direction) than the first printed circuit board 310, the end of the ground pin 230 may be located within the interference-avoidance opening 335, thereby avoiding contact between the ground pin 230 and the third printed circuit board 330.

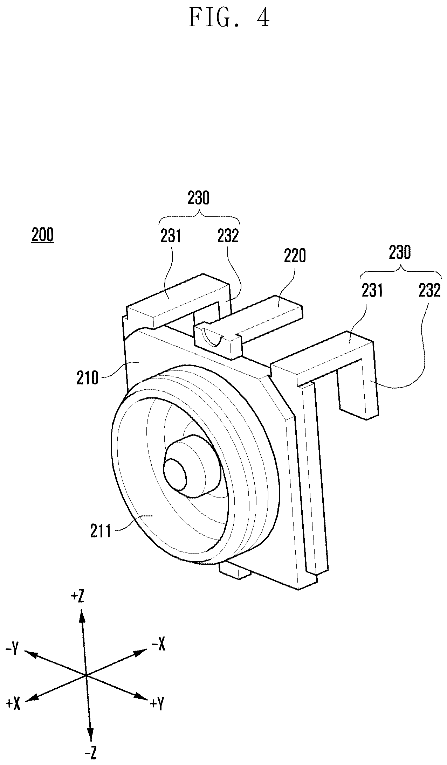

FIG. 4 illustrates the connector 200 according to an embodiment of the disclosure.

The connector 200 according to an embodiment of the disclosure may include a body 210, a signal pin 220, and/or a ground pin 230.

In an embodiment, the body 210 of the connector 200 may include a plate shape extending in the vertical direction (e.g., the z-axis direction) and the lateral direction (e.g., the y-axis direction) of the connector 200.

In an embodiment, the body 210 may include a coupling region 211. The coupling region 211 may be disposed in one direction (e.g., the positive x-axis direction) of the body 210. A cable 1040 (see FIG. 10A) may be coupled to the coupling region 211.

In an embodiment, the signal pin 220 and the ground pin 230 may be arranged at one end of the body 210. For example, the signal pin 220 and the ground pin 230 may be arranged at the end of the body 210 in the positive z-axis direction.

In an embodiment, the signal pin 220 may extend away from one end of the body 210. For example, the signal pin 220 may from one end of the body 210 in the longitudinal direction of the connector 200 (e.g., the negative x-axis direction), away from the body 210.

In an embodiment, the signal pin 220 and the ground pin 230 may be spaced apart from each other. For example, the signal pin 220 and the ground pin 230 may be spaced apart from each other in the lateral direction (e.g., the y-axis direction) of the connector 200.

In an embodiment, at least a portion of the connector 200 may be configured in a shape similar to a dual inline package (DIP) type-pin. For example, at least a portion of the ground pin 230 of the connector 200 may have a bent shape.

In an embodiment, the ground pin 230 may include a support region 231 and/or a contact region 232. The support region 231 may extend along the longitudinal direction (e.g., the x-axis direction) of the connector 200. The contact region 232 may extend along the vertical direction (e.g., the z-axis direction) of the connector 200.

In an embodiment, the support region 231 may be a region disposed on one surface of the multilayer printed circuit board 300 (see FIG. 3A). The support region 231 may be supported by one surface of the multilayer printed circuit board 300 (see FIG. 3A).

In an embodiment, the contact region 232 of the ground pin 230 may be bent and extend from the support region 231. The contact region 232 may be a region that is inserted into the second conductive pad 312 (see FIG. 3A).

In an embodiment, the contact region 232 of the ground pin 230 may be joined to the second conductive pad 312 by soldering (see FIG. 3A).

In an embodiment, when the connector 200 is mounted on the printed circuit board 300 (see FIG. 3A), a portion of the signal pin 220 and a portion of the ground pin 230 may be used as points for holding and lifting the connector 200.

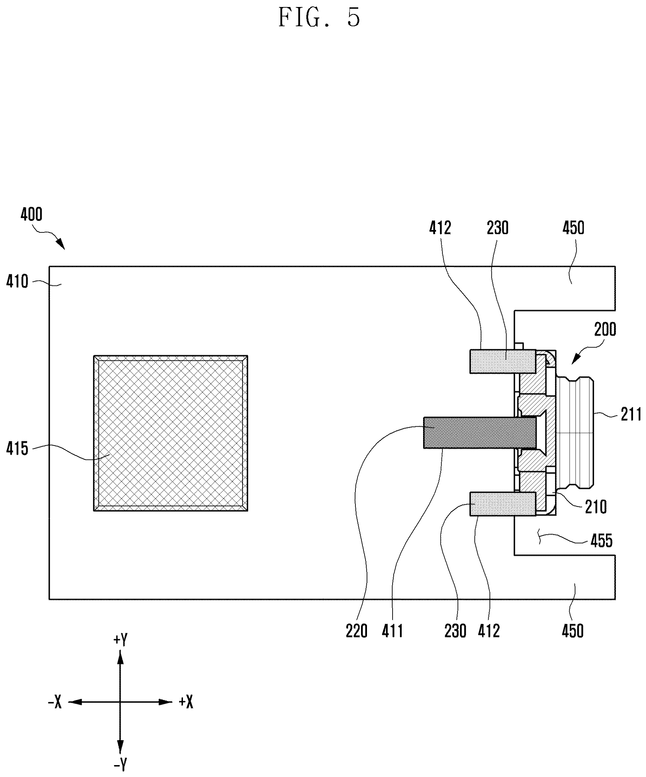

FIG. 5 illustrates a multilayer printed circuit board 400 according to an embodiment of the disclosure.

In an embodiment, the multilayer printed circuit board 400 may include a first printed circuit board 410. The first printed circuit board 410 may include a first conductive pad 411 and/or a second conductive pad 412.

In an embodiment, the first conductive pad 411 and the second conductive pad 412 may be substantially the same as the first conductive pad 311 and the second conductive pad 312 of FIGS. 3A and 3B, respectively.

In an embodiment, an electronic component 415 may be disposed on one surface of the multilayer printed circuit board 400. The electronic component 415 may be an integrated circuit (IC) included in an electronic device 101 (see FIG. 1). For example, the electronic component 415 may be the processor 120 (see FIG. 1) and/or the memory 130 (see FIG. 1) in the form of an integrated circuit.

In an embodiment, the multilayer printed circuit board 400 may include a protection region 450 and/or an installation space 455.

The multilayer printed circuit board 400 according to an embodiment, as shown in FIG. 5, may include at least a portion of the multilayer printed circuit board 300 shown in FIG. 3A. For example, the multilayer printed circuit board 400 may include the first printed circuit board 310, the second printed circuit board 320, and/or the third printed circuit board 330 shown in FIG. 3A. Compared to the multilayer printed circuit board 300 of FIG. 3A, the multilayer printed circuit board 400 of FIG. 5 may further include the protection region 450 and the installation space 455.

In an embodiment, the protection region 450 may be an area in which a portion of the multilayer printed circuit board 400 extends outward in one direction relative to the remaining region. For example, the protection region 450 may be configured such that a portion of the first printed circuit board 410, a portion of the second printed circuit board 320 (see FIG. 3A), and/or a portion of the third printed circuit board 330 (see FIG. 3A), which are included in the multilayer printed circuit board 400, extend in the longitudinal direction (e.g., the x-axis direction) of the multilayer printed circuit board 400.

In an embodiment, the length of the protection region 450 extending in one direction may be substantially equal to the length of the connector 200 extending in the same direction. For example, the length of the protection region 450 extending in the longitudinal direction (e.g., the x-axis direction) of the multilayer printed circuit board 400 may be substantially equal to the length of the connector 200 extending in the longitudinal direction (e.g., the x-axis direction) of the connector 200.

In an embodiment, the protection regions 450 may be disposed at one end and the other end of the multilayer printed circuit board 400. For example, one protection region 450 may extend in the longitudinal direction (e.g., the x-axis direction) from one end of the multilayer printed circuit board 400 (e.g., the end of the multilayer printed circuit board 400 in the positive y-axis direction), and the other protection region 450 may extend in the longitudinal direction (e.g., the x-axis direction) from the other end located opposite the one end of the multilayer printed circuit board 400.

In an embodiment, the installation space 455 may be defined between the two protection regions 450. The installation space 455 may be a space in which the connector 200 is disposed.

In an embodiment, the connector 200 may be disposed on one side of the multilayer printed circuit board 400. For example, the connector 200 may be disposed in the positive x-axis direction of the multilayer printed circuit board 400.

In an embodiment, the protection region 450 may extend to surround at least a portion of the connector 200. For example, the protection region 450 may be disposed in one and/or the opposite direction of the connector 200 to be spaced apart from the connector 200, and may extend in a shape that partially surrounds the connector 200.

In an embodiment, the protection region 450 may serve to protect the connector 200 from external impact. The protection region 450 may surround at least a portion of the connector 200 and may prevent or reduce direct impact applied to the connector 200.

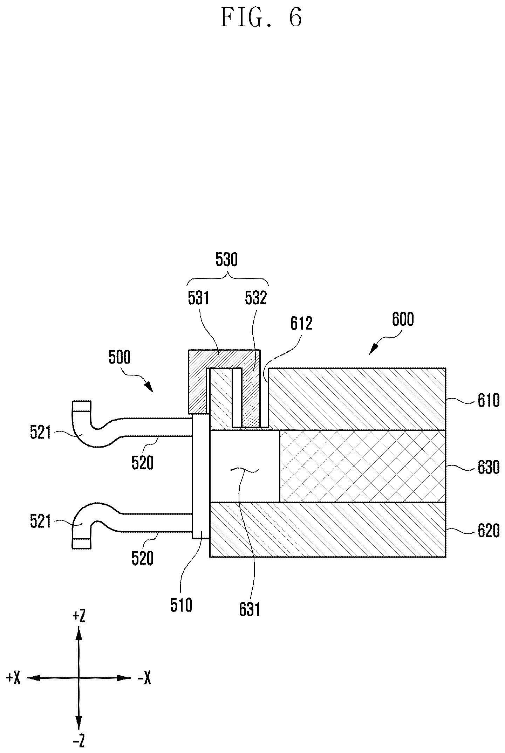

FIG. 6 illustrates a cable support member 500 and a multilayer printed circuit board 600 according to an embodiment of the disclosure.

The multilayer printed circuit board 600 according to an embodiment shown in FIG. 6 may refer to the multilayer printed circuit board 300 of FIG. 3A or may be substantially the same as the multilayer printed circuit board 300 of FIG. 3A.

In an embodiment, the multilayer printed circuit board 600 may include a first printed circuit board 610, a second printed circuit board 620, and/or a third printed circuit board 630.

In an embodiment, the cable support member 500 may be disposed on one side of the multilayer printed circuit board 600. For example, the cable support member 500 may be disposed on a lateral surface of the multilayer printed circuit board 600 facing the positive x-axis direction.

In an embodiment, the cable support member 500 may include a body 510, a guide region 520, and/or a fixing region 530.

In an embodiment, the body 510 of the cable support member 500) may be a region disposed on a lateral surface of the multilayer printed circuit board 600. For example, the body 510 may be disposed on a lateral surface of the multilayer printed circuit board 600 facing the positive x-axis direction.

In an embodiment, the body 510 may be connected to the guide region 520 and the fixing region 530.

In an embodiment, the guide region 520 may be arranged at one end and the other end of the body 510. The guide region 520 may extend in a direction opposite to the multilayer printed circuit board 600 with respect to the body 510.

In an embodiment, the cable support member 500 may include two guide regions 520. A cable 1040 (see FIG. 10A) may be arranged between the two guide regions 520.

In an embodiment, the cable 1040 (see FIG. 10A) may be disposed while being sandwiched between the two guide regions 520.

In FIG. 6, the cable support member 500 is illustrated as including two guide regions 520. However, this is merely an example, and the cable support member 500 may include only one guide region 520. The cable 1040 (see FIG. 10A) may be supported while being disposed in one direction of the single guide region 520.

In an embodiment, the guide region 520 may include a cable fixing portion 521 at the end thereof. The cable fixing portion 521 may be a region in which at least a portion of the guide region 520 is bent and extends. The guide region 520 may be bent into a convex shape from the cable fixing portion 521 toward the direction in which the cable 1040 (see FIG. 10A) is disposed. The cable fixing portion 521 may serve to prevent the cable 1040 (see FIG. 10A) from being detached to the outside while the cable is disposed on the cable support member 500.

In an embodiment, at least a portion of the cable support member 500 may be configured in a shape similar to a dual inline package (DIP)-type pin. For example, the fixing region 530 of the cable support member 500 may have a bent shape in at least a portion thereof.

In an embodiment, the fixing region 530 may be configured by extending from the body 510. For example, the fixing region 530 may extend from one end of the body 510 (from the end of the body 510 in the positive z-axis direction).

In an embodiment, the fixed region 530 may include a first region 531 and/or a second region 532. The first region 531 may be a region disposed on one surface of the multilayer printed circuit board 600.

In an embodiment, the second region 532 may be a region that is bent from the first region 531 and extends in the vertical direction (e.g., the z-axis direction) of the cable support member 500.

In an embodiment, the first printed circuit board 610 may include a fixing opening 612. The fixing opening 612 may be an opening into which a portion of the fixing region 530 of the cable support member 500 is inserted.

In an embodiment, the second region 532 of the fixing region 530 may be inserted into the fixing opening 612. The second region 532 may be joined to at least a portion of the fixing opening 612 while being inserted into the fixing opening 612. The second region 532 may be joined to at least a portion of the fixing opening 612 to allow the position of the cable support member 500 to be fixed at a lateral surface of the multilayer printed circuit board 600.

In an embodiment, the third printed circuit board 630 may include a cutout region 631. The cutout region 631 may be a region obtained by cutting a portion of the third printed circuit board 630. For example, a portion of the third printed circuit board 630 that overlaps the second region 532 of the fixing region 530 of the cable support member 500 may be cut out. Since the third printed circuit board 630 is cut out, interference between the third printed circuit board 630 and the fixing region 530 of the cable support member 500 may be prevented in the cutout region 631.

In an embodiment, the multilayer printed circuit board 600 may serve to support the cable support member 500. For example, the multilayer printed circuit board 600 may be in contact with the body 510 of the cable support member 500, thereby supporting the cable support member 500 such that the cable support member 500 maintains a predetermined position thereof.

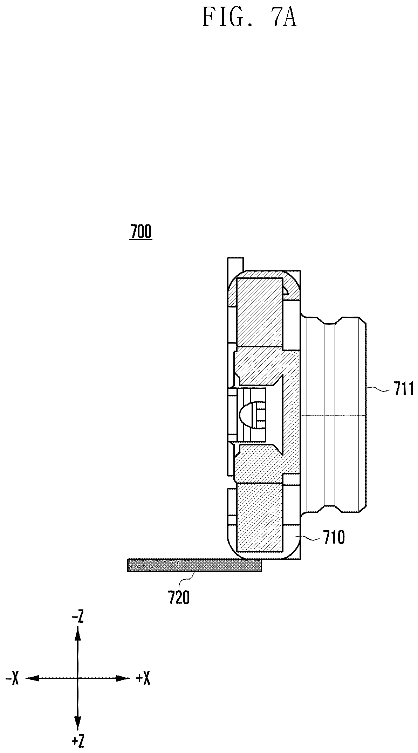

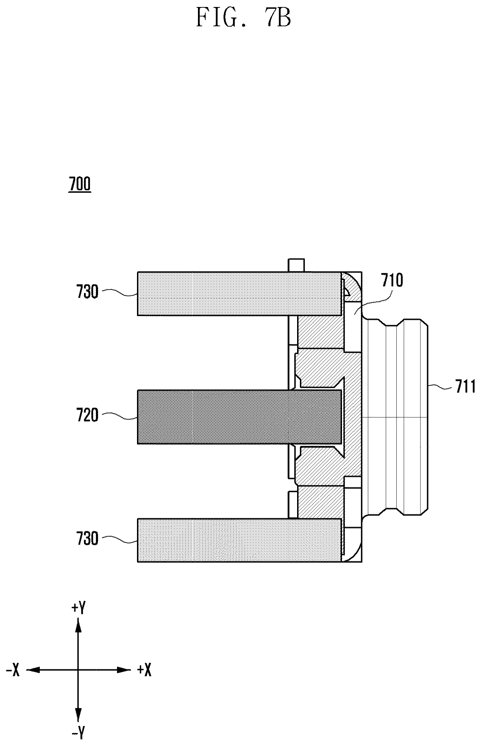

FIGS. 7A and 7B each illustrate a connector 700 according to an embodiment of the disclosure.

In explaining the connector 700 according to an embodiment of the disclosure, the longitudinal direction of the connector 700 may refer to the x-axis direction, and the lateral direction of the connector 700 may refer to the y-axis direction. The vertical direction of the connector 700 may refer to the z-axis direction. The vertical direction of the connector 700 may be a direction perpendicular to the longitudinal direction and the lateral direction of the connector 700.

FIG. 7A illustrates the connector 700 according to an embodiment of the disclosure when viewed in the lateral direction of the connector 700. FIG. 7B illustrates the connector 700 according to an embodiment of the disclosure when viewed in the vertical direction of the connector 700.

The function of the connector 700 according to an embodiment of the disclosure may be substantially the same as the function of the connector 200 illustrated in FIG. 2A.

The connector 700 according to an embodiment of the disclosure may include a body 710, a signal pin 720, and/or a ground pin 730.

In an embodiment, the body 710 may extend in the longitudinal direction of the connector 700 (e.g., the z-axis direction). The signal pin 720 and the ground pin 730 may be arranged on at least a portion of the body 710.

In an embodiment, the body 710 may include a coupling region 711. The coupling region 711 may extend in one direction of the body 710 (e.g., the positive x-axis direction). The coupling region 711 may be a region to which a cable 1040 (see FIG. 10A) is coupled.

In an embodiment, the signal pin 720 and the ground pin 730 may be arranged on one end of the body 710. For example, the signal pin 720 and the ground pin 730 may be arranged on the end of the body 710 in the positive z-axis direction.

In an embodiment, the signal pin 720 may extend in the longitudinal direction of the connector 700. For example, the signal pin 720 may extend from one end of the body 710 in the longitudinal direction (e.g., the x-axis direction) of the connector 700 away from the body 710.

In an embodiment, the ground pin 730 may extend in the longitudinal direction of the connector 700. For example, referring to FIGS. 7A and 7B, the ground pin 730 may extend from one end of the body 710 along the longitudinal direction (e.g., the x-axis direction) of the connector 700 away from the body 710.

The ground pin 730 of the connector 700 according to an embodiment may have a different shape from the ground pin 230 of the connector 200 shown in FIG. 2A. For example, the ground pin 230 of FIG. 2A includes a shape that is bent and extends from at least in a portion thereof, while the ground pin 230 of FIG. 7A may extend only in one direction (e.g., the x-axis direction) without bending.

In an embodiment, the connector 700 may include at least one ground pin 730. For example, referring to FIG. 7B, the connector 700 may include two ground pins 730. However, the number of ground pins 730 illustrated in FIG. 2B is an example, and the number of ground pins 730 may not be limited thereto.

In an embodiment, the ground pins 730 may be arranged in the lateral direction (e.g., the y-axis direction) of the connector 700 and spaced apart from each other with the signal pin 720 positioned therebetween.

In an embodiment, the two ground pins 730 may be arranged symmetrically with respect to the signal pin 720. For example, one ground pin 730 may be positioned in one direction with respect to the signal pin 720, and the other ground pin 730 may be positioned in the other direction with respect to the signal pin 720.

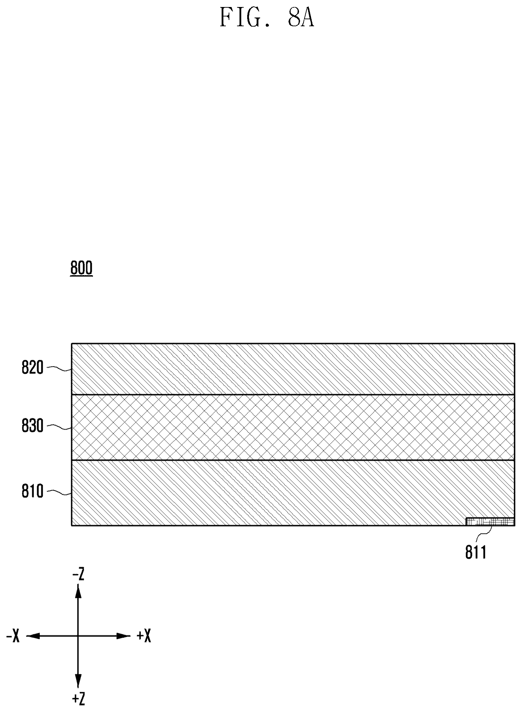

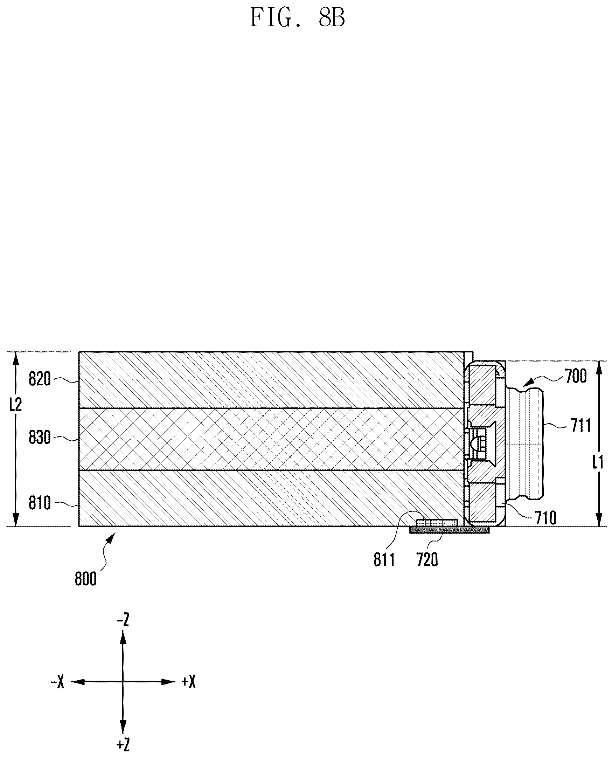

FIGS. 8A and 8B each illustrate a multilayer printed circuit board 800 and the connector 700 arranged on the multilayer printed circuit board 800 according to an embodiment of the disclosure.

In an embodiment, the vertical direction of the multilayer printed circuit board 800 may refer to the z-axis direction. The longitudinal direction of the multilayer printed circuit board 800 may refer to the x-axis direction. The lateral direction of the multilayer printed circuit board 800 may be a direction perpendicular to the vertical direction and the longitudinal direction.

The function of the multilayer printed circuit board 800 according to an embodiment may be substantially the same as the function of the multilayer printed circuit board 300 illustrated in FIG. 3A.

In an embodiment, the multilayer printed circuit board 800 may include a first printed circuit board 810, a second printed circuit board 820, and/or a third printed circuit board 830.

In an embodiment, along the height direction (e.g., the z-axis direction) of the multilayer printed circuit board 800, the first printed circuit board 810, the third printed circuit board 830, and the second printed circuit board 820 may be stacked in that order. For example, the third printed circuit board 830 may be positioned between the first printed circuit board 810 and the second printed circuit board 820.

In an embodiment, the connector 700 may be positioned on one side of the multilayer printed circuit board 800. For example, referring to FIG. 8B, the connector 700 may be positioned on a lateral surface of the multilayer printed circuit board 800 facing the positive x-axis direction.

In an embodiment, the first printed circuit board 810 may include a conductive pad 811. The conductive pad 811 of the first printed circuit board 810 may be a pad that is in contact with at least a portion of the connector 700.

In an embodiment, the first printed circuit board 810 may include a plurality of conductive pads 811. Each of the plurality of conductive pads 811 may be in contact with the connector 700. For example, one or more conductive pads 811 of the plurality of conductive pads 811 may be in contact with the signal pin 720 of the connector 700 and may be electrically connected thereto. One or more of the remaining conductive pads 811 of the plurality of conductive pads 811 may be in contact with the ground pin 730 of the connector 700 and may be electrically connected thereto.

According to an embodiment, the ground pin 730 of the connector 700 may extend only in one direction (e.g., the x-axis direction), and accordingly, the ground pin 730 may be spaced apart from the third printed circuit board 830. According to an embodiment, the third printed circuit board 830 may not include a structure (e.g., the cutout region 331, see FIG. 3A) for avoiding interference with the ground pin 730.

In an embodiment, the multilayer printed circuit board 800 may serve to support the connector 700. For example, the multilayer printed circuit board 800 may be in contact with the body 710 of the connector 700, thereby supporting the connector 700 such that the connector 700 maintains a predetermined position thereof.

Referring to FIG. 8B, the multilayer printed circuit board 800 may extend farther in the vertical direction (e.g., the z-axis direction) than the length of the connector 700 extending in the same direction. For example, as shown in FIG. 8B, the second length (L2), which is the length of the multilayer printed circuit board 800, may be greater than the first length (L1), which is the length of the connector 700. The second length (L2) may be longer than the first length (L1), thereby allowing the connector 700 to be stably supported by the multilayer printed circuit board 800.

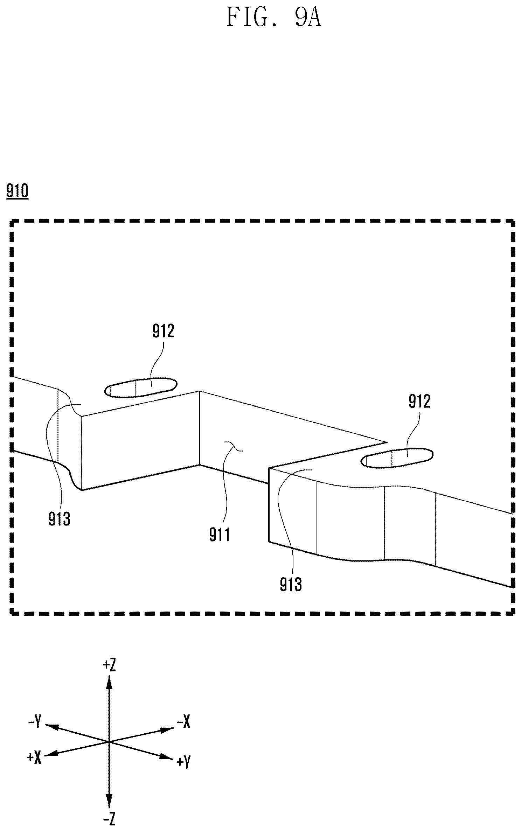

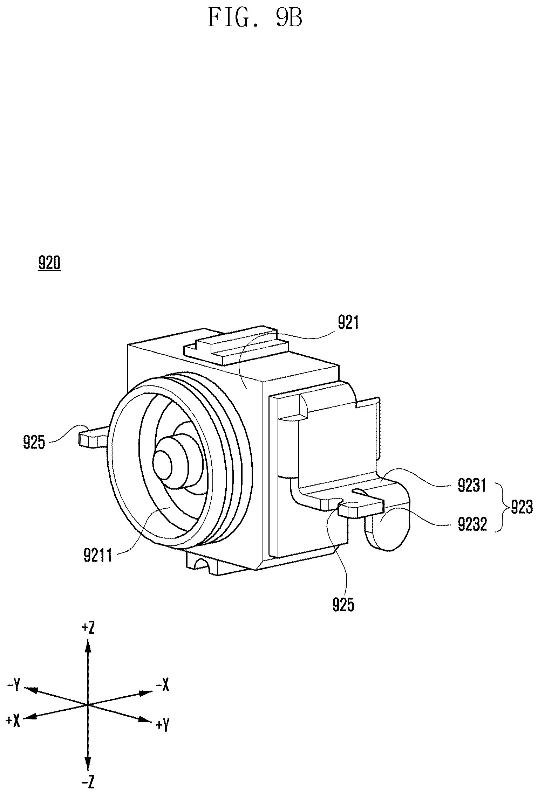

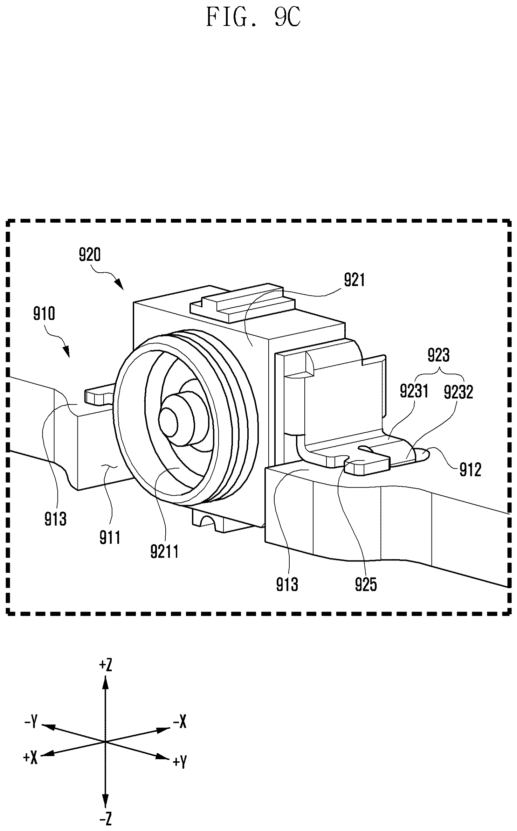

FIGS. 9A, 9B, and 9C each illustrate a printed circuit board 910 and a connector 920 according to an embodiment of the disclosure.

FIG. 9A illustrates the printed circuit board 910 according to an embodiment. FIG. 9B illustrates the connector 920 according to an embodiment. FIG. 9C illustrates the connector 920 disposed on the printed circuit board 910 according to an embodiment.

In describing the printed circuit board 910 and the connector 920 according to an embodiment of the disclosure, the longitudinal direction may refer to the x-axis direction, and the lateral direction may refer to the y-axis direction. The vertical direction of the printed circuit board 910 and the connector 920 may refer to the z-axis direction.

Referring to FIG. 9A, the printed circuit board 910 may include an installation space 911, a conductive pad 912, and/or a protrusion 913.

In an embodiment, the installation space 911 may have a shape configured by recessing a portion of the printed circuit board 910 toward the inner side of the printed circuit board 910 (e.g., the negative x-axis direction). The installation space 911 may serve as a space in which the connector 920 is disposed.

In an embodiment, the conductive pad 912 may be an aperture-shaped pad. For example, the conductive pad 912 may be an aperture-shaped pad that extends along the vertical direction (e.g., the z-axis direction) of the printed circuit board 910.

In an embodiment, the conductive pad 912 may be disposed in one direction (e.g., the positive y-axis direction) of the installation space 911 and in the other direction (e.g., the negative y-axis direction) opposite to the one direction.

In an embodiment, the conductive pad 912 may include a conductive material that enables electrical connection to a component located outside the printed circuit board 910.

In an embodiment, the protrusion 913 may be configured so that at least a portion thereof protrudes toward the outside (e.g., the positive x-axis direction) of the printed circuit board 910.

In an embodiment, the protrusion 913 may serve to support at least a portion of the connector 920.

In an embodiment, the protrusion 913 may serve to protect the connector 920. For example, the protrusion 913 may surround at least a portion of the connector (920) in one direction and the other direction of the connector 920 to protect the connector 920 from external impact.

Referring to FIG. 9B, the connector 920 may include a body 921, a ground pin 923, and/or a support pin 925.

In an embodiment, the body 921 may extend in the vertical direction (e.g., the z-axis direction) and the lateral direction (e.g., the y-axis direction) of the connector 920 and have a thickness in the longitudinal direction (e.g., the x-axis direction).

In an embodiment, the ground pin 923 and the support pin 925 may be arranged on one side and the other side of the body 921. For example, the ground pin 923 and the support pin 925 may be arranged on a lateral surface of the body 921 facing the positive y-axis direction and/or a lateral surface of the body 921 facing the negative y-axis direction.

In an embodiment, the ground pin 923 and the support pin 925 may extend from a central point of the body 921. For example, the ground pin 923 and the support pin 925 may extend from a central point of one side and the other side of the body 921 (e.g., a central point with respect to the z-axis direction).

The ground pin 923 and the support pin 925 of the connector 920 according to an embodiment may extend from the central point of the body 921, thereby allowing the connector 920 to be more stably supported by the printed circuit board 910. When the ground pin 923 and the support pin 925 extend from one end or the other end of the body 921, the body 921 of the connector 920 may protrude in the vertical direction (e.g., the z-axis direction) from one surface of the printed circuit board 910 and thus may be vulnerable to external impact. However, when the ground pin 923 and the support pin 925 extend from the central point of the body 921, the length of the connector body 921 protruding from one surface of the printed circuit board 910 may be reduced, thereby allowing the connector 920 to more stably maintain a position thereof even under external impact.

In an embodiment, the body 921 may include a coupling region 9211. The coupling region 9211 may extend in one direction (e.g., the positive x-axis direction) of the body 921. The coupling region 9211 may be a region to which a cable 1040 (see FIG. 10A) is coupled.

In an embodiment, the ground pin 923 may include a support region 9231 and/or a contact region 9232. The support region 9231 may extend along the lateral direction (e.g., the y-axis direction) of the connector 920. The contact region 9232 may extend along the vertical direction (e.g., the z-axis direction) of the connector 920.

In an embodiment, the support region 9231 may be a region disposed on one surface of the printed circuit board 910. Referring to FIG. 9C, the support region 9231 may be supported by one surface of the printed circuit board 910.

In an embodiment, the contact region 9232 of the ground pin 923 may be bent and extend from the support region 9231. Referring to FIG. 9C, the contact region 9232 may be inserted into the conductive pad 912.

In an embodiment, the contact region 9232 of the ground pin 923 may be bonded to the conductive pad 912. For example, the contact region 9232 may be bonded to the conductive pad 912 by soldering.

In an embodiment, the ground pin 923 may be in contact with the conductive pad 912 and may be electrically connected thereto. The conductive pad 912 may be electrically connected to the ground (e.g., a ground pattern) of the printed circuit board 910. The ground pin 923 may be in contact with the conductive pad 912 at the contact region 9232 and electrically connected to the ground of the printed circuit board 910.

In an embodiment, the support pin 925 may extend along the lateral direction (e.g., the y-axis direction) of the connector 920. Referring to FIG. 9C, the support pin 925 may be arranged on one surface of the printed circuit board 910 and may be supported by the printed circuit board 910.

In an embodiment, the support pin 925 may be a signal pin (e.g., 220, see FIG. 2B) that serves to transmit and receive electrical signals. For example, the connector 920 may be electrically connected to the printed circuit board 910 via the support pin 925 to transmit and receive signals.

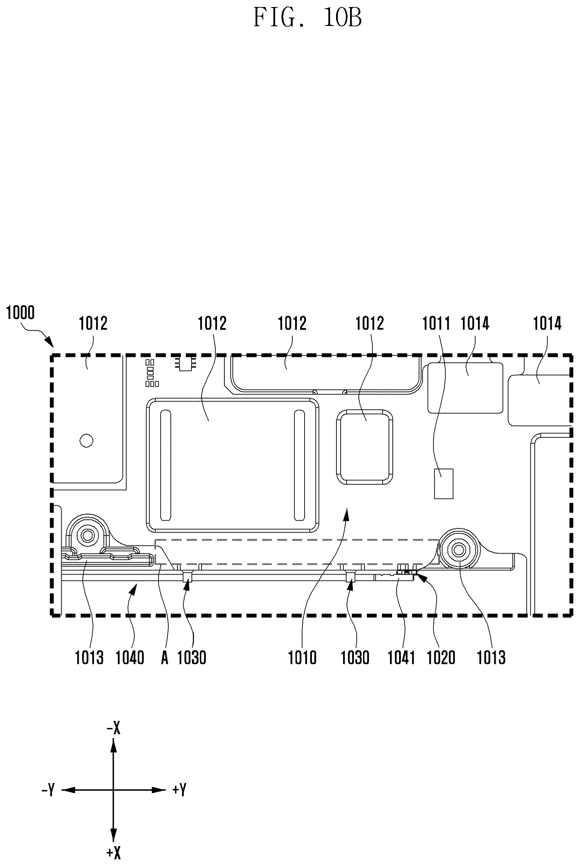

FIGS. 10A and 10B each illustrate an electronic device 1000 according to an embodiment of the disclosure.

In describing the electronic device 1000 according to an embodiment of the disclosure, the longitudinal direction of the electronic device 1000 may refer to the y-axis direction, and the lateral direction of the electronic device 1000 may refer to the x-axis direction. The vertical direction of the electronic device 1000 may refer to the z-axis direction.

Referring to FIGS. 10A and 10B, the electronic device 1000 according to an embodiment may include a printed circuit board 1010, an electronic component 1011, a shield member 1012, a board support member 1013, a board connection 1014, a connector 1020, a cable support member 1030, a cable 1040, and/or a connector support member 1050.

In an embodiment, the printed circuit board 1010 may refer to the multilayer printed circuit board 300 illustrated in FIG. 3A.

In an embodiment, the connector 1020 may refer to the connector 200 illustrated in FIG. 4. The cable support member 1030 may refer to the cable support member 500 illustrated in FIG. 6.

In an embodiment, the electronic component 1011, the shield member 1012, and the board connection 1014 may be arranged on one surface of the printed circuit board 1010.

In an embodiment, the electronic component 1011 may be an integrated circuit (IC) included in the electronic device 101 (see FIG. 1). For example, the electronic component 1011 may be a processor 120 and/or a memory 130 in the form of an integrated circuit (see FIG. 1).

In an embodiment, the shielding member 1012 may be a member disposed to cover the internal components of the electronic device 1000. The shielding member 1012 may serve to shield noise generated by components of the electronic device 1000.

In an embodiment, the board connection 1014 may be a connector that connects the printed circuit board 1010 to another configuration. For example, the board connection 1014 may be a connector for connecting the printed circuit board 1010 to a flexible printed circuit board (not shown) separate from the printed circuit board 1010.

In an embodiment, the board support member 1013 may be disposed on the other surface, which is the opposite to one surface of the printed circuit board 1010. The board support member 1013 may serve to support the printed circuit board 1010.

In an embodiment, the connector support member 1050 may be a member that is disposed to support the connector 1020. For example, the connector support member 1050 may be in contact with at least a portion of the connector 1020, thereby supporting the connector 1020 such that connector 1020 maintains a predetermined position thereof.

In an embodiment, the connector support member 1050 may include an elastic material. For example, the connector support member 1050 may include rubber having elastic properties.

Referring to FIG. 10A, the connector support member 1050 according to an embodiment may be disposed on the board support member 1013. The length (e.g., the length in the z-axis direction) obtained by stacking the printed circuit board 1010, the board support member 1013, and the connector support member 1050 may be substantially equal to or longer than the length (e.g., the length in the z-axis direction) of the connector 1020.

Referring to FIG. 10A, the connector support member 1050 according to an embodiment is illustrated as being disposed on the board support member 1013. However, the connector support member 1050 is an example and may be disposed directly on the printed circuit board 1010. In this case, the length (e.g., the length in the z-axis direction) obtained by stacking the printed circuit board 1010 and the connector support member 1050 may be substantially equal to and longer than the length (e.g., the length in the z-axis direction) of the connector 1020.

In an embodiment, the connector support member 1050 may be integrated with the printed circuit board 1010 and/or the board support member 1013 rather than being configured as a separate component from the printed circuit board 1010 and/or the board support member 1013. For example, a portion of the printed circuit board 1010 and/or the board support member 1013 may be configured in a shape that extends in the vertical direction (e.g., the z-axis direction) similar to the shape of the connector support member 1050.

When the electronic device 1000 includes a plurality of antenna modules 197 (see FIG. 1), at least one of the antenna modules 197 (see FIG. 1) may be located outside the printed circuit board 1010. In an embodiment, the cable 1040 may be a component (e.g., a coaxial cable) for electrically connecting the antenna module 197 (see FIG. 1) located outside the printed circuit board 1010 to the printed circuit board 1010.

In an embodiment, the connector 1020 may be a component (e.g., a coaxial connector) to which a cable 1040 connected to the antenna module 197 (see FIG. 1) is connected. The connector 1020 and the cable 1040 may be electrically connected to each other to electrically connect the antenna module 197 (see FIG. 1) to the printed circuit board 1010.

In an embodiment, the cable 1040 may be positioned on a lateral surface of the printed circuit board 1010. For example, referring to FIG. 10A, the cable 1040 may be positioned on a lateral surface of the printed circuit board 1010 facing the positive x-axis direction.

In an embodiment, the connector 1020 and the cable support member 1030 may be positioned on one side of the printed circuit board 1010. For example, referring to FIG. 10A, the connector 1020 and the cable support member 1030 may be positioned on a lateral surface of the printed circuit board 1010 facing the positive x-axis direction.

In an embodiment, the cable support member 1030 may serve to support the cable 1040 disposed on a lateral surface of the printed circuit board 1010. At least a portion of the cable 1040 may be fitted into the cable support member 1030, and thus, the position of the cable 1040 may be secured along the lateral surface of the printed circuit board 1010.

In an embodiment, at least a portion of the cable 1040 may be coupled to the connector 1020. For example, the end portion 1041 of the cable 1040 may be coupled to the connector 1020, thereby establishing an electrical connection between the cable 1040 and the connector 1020.

The electronic device 1000 according to an embodiment of the disclosure may include the connector 1020 disposed on one side of the printed circuit board 1010, enabling the cable 1040 to be arranged on the lateral surface of the board. When the cable 1040 is disposed on the lateral surface of the printed circuit board 1010, an available space (A) may be secured on one surface of the printed circuit board 1010.

In an embodiment, securing the available space (A) on one surface of the printed circuit board 1010 may increase the available area for placing components on the printed circuit board 1010.

An electronic device 101 according to an embodiment of the disclosure may include an electronic component 315, a multilayer printed circuit board 300, and a connector 200.

In an embodiment, the electronic component 315 may be disposed on one surface of the multilayer printed circuit board 300.

In an embodiment, the connector 200 may be disposed on one side of the multilayer printed circuit board 300.

In an embodiment, the multilayer printed circuit board 300 may include a first printed circuit board 310 including a first conductive pad 311 electrically connected to the electronic component 315 and a second conductive pad 312 having an aperture shape, a second printed circuit board 320 disposed in an opposite direction of the first printed circuit board 310, and a third printed circuit board 330 disposed between the first printed circuit board 310 and the second printed circuit board 320.

In an embodiment, the connector 200 may include a signal pin 220 in contact with the first conductive pad 311 so as to be electrically connected thereto, a ground pin 230 having at least a portion inserted into the second conductive pad 312 so as to be electrically connected to the second conductive pad 312, and a coupling region 211 which is electrically connected to the signal pin 220 and the ground pin 230, and to which a cable 1040 located outside the connector 200 is coupled.

In an embodiment, the coupling region 211 may be disposed in the lateral direction of the third printed circuit board 330 to face in a direction perpendicular to one surface of the first printed circuit board 310 on which the first conductive pad 311 is disposed.

In an embodiment, the third printed circuit board 330 may include a cutout region 331 disposed at a position on one side of the third printed circuit board 330, the position overlapping the end of the ground pin 230, thereby avoiding interference with the ground pin 230.

In an embodiment, the third printed circuit board 330 may include an interference-avoidance opening 335 disposed at a position overlapping the second conductive pad 312, thereby avoiding interference with the ground pin 230.

In an embodiment, the ground pin 230 may include a support region 231 disposed on one surface of the multilayer printed circuit board 300 and a contact region 232 that is bent and extends from the support region 231 so as to be inserted into the second conductive pad 312.

In an embodiment, the connector 200 may include two ground pins 230, and one ground pin 230 may be spaced apart from the signal pin 220 in one direction of the signal pin 220, and the other ground pin 230 may be spaced apart from the signal pin 220 in the other direction of the signal pin 220.

In an embodiment, the multilayer printed circuit board 400 may include protection regions 450 positioned on one side and the other side of the connector 200 and spaced apart from each other, and an installation space 455 disposed between the protection regions 450, wherein the connector 200 may be disposed in the installation space 455.

In an embodiment, the length of the multilayer printed circuit board 300 extending in the vertical direction of the multilayer printed circuit board 300 may be longer than the length of the connector 200 extending in the vertical direction of the connector 200.

In an embodiment, the electronic device may further include a connector support member 1050 disposed in one direction of the multilayer printed circuit board 300, and the length obtained by stacking the multilayer printed circuit board 300 and the connector support member 1050 in the vertical direction (e.g., the z-axis direction) of the electronic device 1000 may be longer than the length of the connector 200 extending in the vertical direction of the electronic device 1000.

In an embodiment, the electronic device may further include a cable support member 500 disposed on one side of the multilayer printed circuit board 600, and the cable support member 500 may include a guide region 520 configured to support a cable 1040 disposed in the electronic device, and a fixing region 530 configured to fix the cable support member 500 to the multilayer printed circuit board 600.

In an embodiment, the cable support member 500 may include two guide regions 520 that extend away from the multilayer printed circuit board 600, and the cable 1040 may be disposed to be sandwiched between the two guide regions 520.

In an embodiment, the fixing region 530 may include a first region 531 disposed on one surface of the multilayer printed circuit board 600 and a second region 532 that is bent and extends from the first region 531 so as to be inserted into at least a portion of the multilayer printed circuit board 600.

An electronic device 101 according to an embodiment of the disclosure may include a multilayer printed circuit board 800 and a connector 700.

In an embodiment, the multilayer printed circuit board 800 may include a plurality of conductive pads 811 on one surface thereof.

In an embodiment, the connector 700 may be disposed on one side of the multilayer printed circuit board 800.

In an embodiment, the connector 700 may include a signal pin 720 electrically connected to one or more conductive pads 811 among the plurality of conductive pads 811, and a ground pin 730 electrically connected to one or more of the remaining conductive pads 811 among the plurality of conductive pads 811.

In an embodiment, the length of the multilayer printed circuit board 800 extending in the vertical direction of the multilayer printed circuit board 800 may be longer than the length of the connector 700 extending in the vertical direction of the connector 700.

In an embodiment, the multilayer printed circuit board 800 may include a first printed circuit board 810 including a plurality of conductive pads 811, a second printed circuit board 820 disposed in a direction opposite to the first printed circuit board 810, and a third printed circuit board 830 disposed between the first printed circuit board 810 and the second printed circuit board 820, wherein the first printed circuit board 810 is disposed to be in contact with one end of the connector 700, and the second printed circuit board 820 is disposed to be in contact with the other end of the connector 700.

In an embodiment, each of the ground pin 730 and the signal pin 720 may extend in a direction parallel to one surface of the multilayer printed circuit board 800.

In an embodiment, the connector 700 may include two ground pins 730, wherein one ground pin 730 is spaced apart from the signal pin 720 in one direction of the signal pin 720, and the other ground pin 730 is spaced apart from the signal pin 720 in the other direction of the signal pin 720.

In an embodiment, the multilayer printed circuit board 800 may include protection regions 450 extending from one side and the other side of the connector 700, respectively, and spaced apart from each other, and an installation space 455 disposed between the protection regions 450, wherein the connector 700 is disposed in the installation space 455.

In an embodiment, the electronic device may further include a cable 1040 disposed on one side of the multilayer printed circuit board 800, an end of the cable 1040 being connected to a connector 700.

The electronic device 101 according to an embodiment of the disclosure may include a printed circuit board 910 and a connector 920.

In an embodiment, the connector 920 may be disposed on one side of the printed circuit board 910.

In an embodiment, the printed circuit board 910 may include an installation space 911 which is recessed toward the inner side of the printed circuit board 910 and in which the connector 920 is disposed, and conductive pads 912 respectively disposed in one direction and the other direction of the installation space 911, each of the conductive pads 912 having an aperture shape.

In an embodiment, the connector 920 may include ground pins 923 respectively extending from one side and the other side of the connector 920, at least a portion of each of the ground pins 923 being inserted into the conductive pad 912 so as to be electrically connected to the conductive pad 912.

In an embodiment, the ground pin 923 may include a support region 9231 disposed on one surface of the printed circuit board 910 and a contact region 9232 that is bent and extends from the support region 9231 so as to be inserted into the conductive pad 912.

In an embodiment, the ground pin 923 may extend from the center portion of the connector 920 toward the printed circuit board 910, based on the vertical direction (e.g., the z-axis direction) of the connector 920.

The electronic device according to an embodiment of the disclosure may be one of various types of electronic devices. The electronic device may include, for example, a portable communication device (e.g., a smart phone), a computer device, a portable multimedia device, a portable medical device, a camera, a wearable device, or a home appliance. The electronic device according to embodiments of the disclosure is not limited to those described above.

It should be appreciated that an embodiment of the disclosure and the terms used therein are not intended to limit the technological features set forth herein to particular embodiments and the disclosure includes various changes, equivalents, or alternatives for a corresponding embodiment. With regard to the description of the drawings, similar reference numerals may be used to designate similar or relevant elements. A singular form of a noun corresponding to an item may include one or more of the items, unless the relevant context clearly indicates otherwise. As used herein, each of such phrases as "A or B," "at least one of A and B," "at least one of A or B," "A, B, or C,""at least one of A, B, and C," and "at least one of A, B, or C," may include all possible combinations of the items enumerated together in a corresponding one of the phrases. Such terms as "a first," "a second," "the first," and "the second" may be used to simply distinguish a corresponding element from another, and does not limit the elements in other aspect (e.g., importance or order). If an element (e.g., a first element) is referred to, with or without the term "operatively" or "communicatively", as "coupled with/to" or "connected with/to" another element (e.g., a second element), it means that the element may be coupled/connected with/to the other element directly (e.g., wiredly), wirelessly, or via a third element.

As used in an embodiment of the disclosure, the term "module" may include a unit implemented in hardware, software, or firmware, and may be interchangeably used with other terms, for example, "logic," "logic block," "component," or "circuit". The "module" may be a single integrated component, or a minimum unit or part thereof, adapted to perform one or more functions. For example, according to an embodiment, the "module" may be implemented in the form of an application-specific integrated circuit (ASIC).

An embodiment of the disclosure may be implemented as software (e.g., the program 140) including one or more instructions that are stored in a storage medium (e.g., the internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Herein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, methods according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., Play Store TM), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each element (e.g., a module or a program) of the above-described elements may include a single entity or multiple entities, and some of the multiple entities may also be separately disposed in another element. According to various embodiments, one or more of the above-described elements or operations may be omitted, or one or more other elements or operations may be added. Alternatively or additionally, a plurality of elements (e.g., modules or programs) may be integrated into a single element. In such a case, according to various embodiments, the integrated element may still perform one or more functions of each of the plurality of elements in the same or similar manner as they are performed by a corresponding one of the plurality of elements before the integration.

According to various embodiments, operations performed by the module, the program, or another element may be carried out sequentially, in parallel, repeatedly, or heuristically, or one or more of the operations may be executed in a different order or omitted, or one or more other operations may be added.

## Claims

1. An electronic device (101) comprising:
an electronic component (315);
a multilayer printed circuit board (300) having the electronic component disposed on one surface thereof; and
a connector (200) disposed on one side of the multilayer printed circuit board,
wherein the multilayer printed circuit board comprises:
a first printed circuit board (310) comprising a first conductive pad (311) electrically connected to the electronic component, and a second conductive pad (312) having an aperture shape;
a second printed circuit board (320); and
a third printed circuit board (330) disposed between the first printed circuit board and the second printed circuit board,
wherein the connector comprises:
a signal pin (220) in contact with the first conductive pad so as to be electrically connected thereto;
a ground pin (230) having at least a portion inserted into the second conductive pad so as to be electrically connected to the second conductive pad; and
a coupling region (211) which is electrically connected to the signal pin and the ground pin, and to which a cable (1040) located outside the connector is coupled, and
wherein the coupling region is disposed in a lateral direction of the third printed circuit board to face in a direction perpendicular to one surface of the first printed circuit board on which the first conductive pad is disposed.

2. The electronic device of claim 1, wherein the third printed circuit board comprises a cutout region (331) disposed at a position on one side of the third printed circuit board, the position overlapping an end of the ground pin, so as to avoid interference with the ground pin.

3. The electronic device of claim 1, wherein the third printed circuit board comprises an interference-avoidance opening (335) disposed at a position overlapping the second conductive pad, so as to avoid interference with the ground pin.

4. The electronic device of claim 1, wherein the ground pin comprises:
a support region (231) disposed on one surface of the multilayer printed circuit board; and
a contact region (232) that is bent and extends from the support region so as to be inserted into the second conductive pad.

5. The electronic device of claim 1, wherein the connector comprises two ground pins,
wherein one ground pin is spaced apart from the signal pin in one direction of the signal pin, and
wherein the other ground pin is spaced apart from the signal pin in the other direction of the signal pin.

6. The electronic device of claim 1, wherein the multilayer printed circuit board (400) comprises:
protection regions (450) positioned on one side and the other side of the connector and spaced apart from each other; and
an installation space (455) disposed between the protection regions, and
wherein the connector is disposed in the installation space.

7. The electronic device of claim 1, wherein a length of the multilayer printed circuit board extending in a vertical direction of the multilayer printed circuit board is longer than a length of the connector extending in a vertical direction of the connector.

8. The electronic device of claim 1, further comprising a connector support member (1050) disposed in one direction of the multilayer printed circuit board,
wherein a length obtained by stacking the multilayer printed circuit board and the connector support member in a vertical direction of the electronic device is longer than a length of the connector extending in the vertical direction of the electronic device.

9. The electronic device of claim 1, further comprising a cable support member (500) disposed on one side of the multilayer printed circuit board,
wherein the cable support member comprises:
a guide region (520) configured to support a cable (1040) disposed in the electronic device; and
a fixing region (530) configured to fix the cable support member to the multilayer printed circuit board.

10. The electronic device of claim 9, wherein the cable support member comprises two guide regions (520) extending away from the multilayer printed circuit board, and
wherein the cable is sandwiched between the two guide regions.

11. The electronic device of claim 9, wherein the fixing region comprises:
a first region (531) disposed on one surface of the multilayer printed circuit board; and
a second region that is bent and extends from the first region so as to be inserted into at least a portion of the multilayer printed circuit board.

12. An electronic device (101) comprising:
a multilayer printed circuit board (800) comprising a plurality of conductive pads (811) on one surface thereof; and
a connector (700) disposed on one side of the multilayer printed circuit board,
wherein the connector comprises:
a signal pin (720) electrically connected to one or more conductive pads among the plurality of conductive pads; and
a ground pin (730) electrically connected to one or more of the remaining conductive pads among the plurality of conductive pads, and
wherein a length of the multilayer printed circuit board extending in a vertical direction of the multilayer printed circuit board is longer than a length of the connector extending in a vertical direction of the connector.

13. The electronic device of claim 12, wherein the multilayer printed circuit board comprises:
a first printed circuit board (810) comprising a plurality of conductive pads;
a second printed circuit board (820); and
a third printed circuit board (830) disposed between the first printed circuit board and the second printed circuit board,
wherein the first printed circuit board is disposed to be in contact with one end of the connector, and
wherein the second printed circuit board is disposed to be in contact with the other end of the connector.

14. The electronic device of claim 12, wherein the connector comprises two ground pins,
wherein one ground pin is spaced apart from the signal pin in one direction of the signal pin, and
wherein the other ground pin is spaced apart from the signal pin in the other direction of the signal pin.

15. The electronic device of claim 12, wherein the multilayer printed circuit board comprises:
protection regions (450) extending from one side and the other side of the connector, respectively, and spaced apart from each other; and
an installation space (455) disposed between the protection regions, and
wherein the connector is disposed in the installation space.
